# EUROPEAN PATENT SPECIFICATION

(11) **EP 1 364 762 B1**
(45) Date of publication and mention of the grant of the patent: **09.08.2006**
(21) Application number: 03011077.9
(22) Date of filing: 20.05.2003
(51) Int. Cl.: B29C 33/68, B32B 27/30, B29K 67/00, B29K 27/12

(54) **Use of a release film**
Trennfolienverwendung
Utilisation d'un film de relâchement

(30) Priority: 23.05.2002 JP 2002148760
(43) Date of publication of application: 26.11.2003
(73) Proprietor: ASAHI GLASS COMPANY LTD., Tokyo 100-8405 (JP)
(72) Inventor: Yamamoto, Satoshi, Ichihara-shi, Chiba (JP); Kaya, Seitoku, Ichihara-shi, Chiba (JP)
(74) Representative: Müller-Boré & Partner Patentanwälte

(56) References cited:
- EP-A- 0 848 031
- EP-A- 0 853 337
- EP-A- 0 970 987
- EP-A- 1 160 270
- WO-A-01/15896
- PATENT ABSTRACTS OF JAPAN vol. 2002, no. 08, 5 August 2002 (2002-08-05) & JP 2002 120335 A (MITSUBISHI PLASTICS IND LTD), 23 April 2002 (2002-04-23)
- DATABASE WPI Section Ch, Week 198030 Derwent Publications Ltd., London, GB; Class A14, AN 1980-52497C XP002251814 & JP 55 077566 A (ASAHI GLASS CO LTD), 11 June 1980 (1980-06-11)
- PATENT ABSTRACTS OF JAPAN vol. 1999, no. 02, 26 February 1999 (1999-02-26) & JP 10 296765 A (SANRITSU SHOJI KK;SHOWA SEIKO KK), 10 November 1998 (1998-11-10)
- PATENT ABSTRACTS OF JAPAN vol. 1997, no. 10, 31 October 1997 (1997-10-31) & JP 09 143435 A (BANDO CHEM IND LTD), 3 June 1997 (1997-06-03)
- PATENT ABSTRACTS OF JAPAN vol. 011, no. 085 (C-410), 14 March 1987 (1987-03-14) & JP 61 241331 A (NITTO ELECTRIC IND CO LTD), 27 October 1986 (1986-10-27)
- PATENT ABSTRACTS OF JAPAN vol. 2000, no. 10, 17 November 2000 (2000-11-17) & JP 2000 195883 A (NITTO DENKO CORP), 14 July 2000 (2000-07-14)

## Description

The present invention relates to the use of a release film in a method for the production of printed wiring boards and semiconductor packages.

In recent years, the density of printed wiring boards became high. Accordingly, multi-layer printed wiring boards having a graduated convexo-concave shape to have a surface mount device such as a semiconductor package on board are employed. In a case where multi-layer printed wiring boards having a graduated cavity part are laminated and molded, it is not easy to uniformly press a product to be molded by a conventional molding method.

JP-A-10-296765 discloses a release film consisting of three layers, wherein a thermoplastic resin for the interlayer becomes in a molten state at the time of molding to improve tight contact to the product to be molded, whereby discharge of an adhesive prepreg from the product to be molded will be prevented. However, with the release film, the product to be molded can not adequately be pressed uniformly, since the fluidity of the thermoplastic resin is too high.

JP-A-2001-138338 discloses a release film comprising a support film having a melting point of at least 110°C and an elastic modulus in tension of from 980 to 6,860 N/mm² and a film made of a fluororesin laminated on at least one side of the support film. However, of the release film, the melting point and the elastic modulus in tension of the support film are high, whereby discharge of an adhesive prepreg from the product to be molded can not adequately be prevented.

EP 0 970 987 A1 describes a tetrafluoroethylene-ethylene copolymer (ETFE) film, wherein polar groups are present on the surface of the film after a surface treatment, and the surface roughness Rₐ is at most the surface roughness Rₐ of the surface of an untreated film, an ETFE film, wherein polar groups are present on the surface of the film after a surface treatment, and the amount of a weak boundary layer is at most one time of the amount of a weak boundary layer on the surface of an untreated film, a laminate employing such a film having an excellent bonding strength, and a process for producing it with a mass production property.

JP-A-2002120335 describes a laminated fluorocarbon resin film for transfer.

EP 0 848 031 A1 describes a surface-treated PFA film, wherein hydroxyl groups and carbonyl groups are present on the surface of the surface-treated PFA film.

JP-A-55077566 describes weather and corrosion resistant laminated PVC sheets obtained by laminating PVC sheets with a fluorine containing resin film via a hot melt adhesive.

Accordingly, it has been desired to develop a release film for multi-layer printed wiring boards, with which a product to be molded can uniformly be pressed, and discharge of an adhesive prepreg from the product to be molded can be prevented.

Under these circumstances, it is an object of the present invention to provide the use of a release film which is excellent in release properties, and with which discharge of an adhesive prepreg from a product to be molded can be prevented, in a method for producing a printed wiring board or a semiconductor package, when the product to be molded can be pressed highly uniformly, and the molded product is excellent in surface smoothness.

The solution to the above technical problem is achieved by providing the subject matter defined in the claims.

In particular, according to the present invention there is provided the use of a release film(4) having a three-layer structure consisting of a layer A (1), a layer B (2) and a layer C (3) laminated in this order, wherein the layer A (1) comprises a fluororesin having a melting point higher than the press molding temperature of a product to be molded, which is from 100 to 240°C, the layer B (2) comprises a thermoplastic resin, which is at least one member selected from the group consisting of an ethylene/vinyl acetate copolymer, an ethylene/acrylic acid copolymer, an ethylene/ethyl acrylate copolymer, an ethylene/methyl acrylate copolymer, an ethylene/methacrylic acid copolymer, an ethylene/methyl methacrylate copolymer and an ionomer resin, having a melting point of from 70 to 100°C, and the layer C (3) comprises a fluororesin or a non-fluororesin having a melting point higher than the above press molding temperature, in a method for producing a printed wiring board or a semiconductor package.

In the accompanying drawings:
Fig. 1: a cross-sectional view illustrating a release film of the present invention.
Fig. 2: a cross-sectional view illustrating a printed wiring board before press molding.
Fig. 3: a cross-sectional view illustrating a release film and a multi-layer printed wiring board at the time of press molding.
Fig. 4: a cross-sectional view illustrating a printed wiring board after press molding.

Now, the present invention will be described in detail with reference to the preferred embodiments.

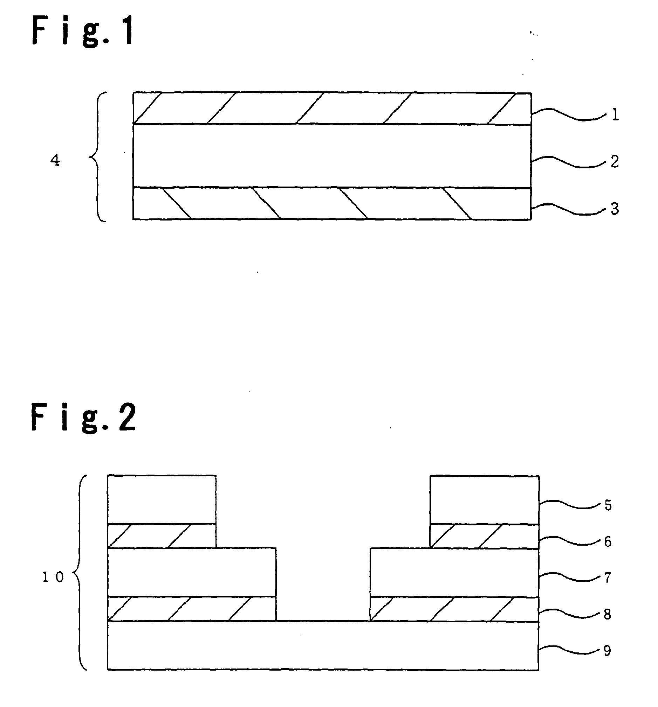

As illustrated in Fig. 1, the release film 4 of the present invention has a three-layer structure consisting of a layer A 1, a layer B 2 and a layer C 3 laminated in this order.

Of the release film of the present invention, the layer A comprises a fluororesin having a melting point higher than the press molding temperature of a product to be molded.

Further, of the release film of the present invention, the layer C comprises a fluororesin or a non-fluororesin having a melting point higher than the above press molding temperature.

As the fluororesin for the layer A and/or the layer C, preferred is a copolymer of tetrafluoroethylene (hereinafter referred to as TFE) with a comonomer. The comonomer may, for example, be a fluoroethylene other than TFE, such as CF₂=CFCl or CF₂=CH₂ (hereinafter referred to as VdF), a fluoropropylene such as CF₂=CFCF₃ (hereinafter referred to as HFP) or CF₂=CHCF₃, a (perfluoroalkyl)ethylene having a carbon number of the perfluoroalkyl group of from 4 to 12, such as CH₂=CHCF₂CF₂CF₂CF₃, CH₂=CFCF₂CF₂CF₂H or CH₂=CFCF₂CF₂CF₂CF₂H, a perfluoro vinyl ether such as R_{f}(OCFXCF₂)ₘOCF=CF₂ (wherein R_{f} is a C₁₋₆ perfluoroalkyl group, X is a fluorine atom or a trifluoromethyl group, and m is an integer of from 0 to 5), or an olefin such as ethylene, propylene or isobutylene. Such comonomers may be used alone or in combination as a mixture of at least two.

Specific examples of the fluororesin include a TFE/ethylene copolymer (hereinafter referred to as ETFE), a TFE/perfluoro(alkyl vinyl ether) copolymer (hereinafter referred to as PFA), a TFE/HFP copolymer (hereinafter referred to as FEP), a TFE/HFP/VdF copolymer and a chlorotrifluoroethylene/ethylene copolymer. The above fluororesins are preferred since their surface energy is low, and excellent release properties will be obtained. Particularly preferred is ETFE, PFA or FEP.

It is also preferred to incorporate, into the fluororesin for the layer A, from 1 to 50 mass% of a fluororubber such as a TFE/propylene copolymer or a VdF/HFP copolymer. By incorporating the fluororubber, plasticity of the release film will further improve. Further, it is also preferred to incorporate from 0.1 to 2 mass% of an antistatic agent to impart antistatic properties into the fluororesin for the layer A.

As the antistatic agent, preferred is a nonionic surfactant, an anionic surfactant, a cationic surfactant, an ampholytic surfactant, an electrically conductive coating or electrically conductive carbon black.

Further, it is also preferred to incorporate, into the fluororesin for the layer A, from 1 to 20 mass% of an inorganic filler such as carbon black, calcium carbonate or silica to decrease gas permeability and water vapor permeability and to improve electrical conductivity and opacifying properties.

In the present invention, the layer B comprises a thermoplastic resin having a melting point of from 70 to 100°C. Within this range, the layer B will easily deform at the time of press molding and fill a space formed by the cavity part in a convexo-concave shape and a hot plate for pressing, whereby discharge of an adhesive prepreg will be prevented, and further, the molded product will be excellent in surface smoothness. The melting point is preferably from 80 to 98°C, more preferably from 84 to 96°C.

As the thermoplastic resin for the layer B, various thermoplastic resins may be employed depending upon the molding conditions of printed wiring board or a semiconductor package. The thermoplastic resin for the layer B is at least one member selected from the group consisting of an ethylene/vinyl acetate copolymer (hereinafter referred to as EVA), an ethylene/acrylic acid copolymer (hereinafter referred to as EAA), an ethylene/ethyl acrylate copolymer (hereinafter referred to as EEA), an ethylene/methyl acrylate copolymer (hereinafter referred to as EMA), an ethylene/methacrylic acid copolymer (hereinafter referred to as EMAA), an ethylene/methyl methacrylate copolymer (hereinafter referred to as EMMA), and an ionomer resin. Such thermoplastic resins may be used alone or in combination as a mixture of at least two.

In the present invention, as the non-fluororesin for the layer C, various resins may optionally be employed, and preferred are polyethylene terephthalate (hereinafter referred to as PET), polybutylene terephthalate (hereinafter referred to as PBT), polycarbonate, polyphenylene sulfide, polyimide, polyphenylene ether, polyether ether ketone, polyethylene naphthalate, polybutylene naphthalate and the like. Such resins are excellent in release properties from a pressing plate of a pressing machine. Particularly, PET which is available at a relatively low cost is more preferred.

Accordingly, specific examples of the combination of layer A/layer B/layer C of the release film of the present invention include ETFE/EVA/PET, ETFE/EAA/PET, ETFE/EEA/PET, ETFE/EMA/PET, ETFE/EMAA/PET, ETFE/EMMA/PET, ETFE/ionomer resin/PET, ETFE/EVA/ETFE, ETFE/EAA/ETFE, ETFE/EEA/ETFE, ETFE/EMA/ETFE, ETFE/EMAA/ETFE, ETFE/EMMA/ETFE, ETFE/ionomer resin/ETFE, ETFE/EAA/PBT, ETFE/EEA/PBT, ETFE/EMA/PBT, ETFE/EMAA/PBT, ETFE/EMMA/PBT and ETFE/ionomer resin/PBT,
ETFE/EVA/ETFE, ETFE/EAA/ETFE, ETFE/EEA/ETFE, ETFE/EMA/ETFE, ETFE/EMAA/ETFE, ETFE/EMMA/ETFE, ETFE/ionomer resin/ETFE, ETFE/EVA/PFA, ETFE/EAA/PFA, ETFE/EEA/PFA, ETFE/EMA/PFA, ETFE/EMAA/PFA, ETFE/EMMA/PFA, ETFE/ionomer resin/PFA, ETFE/EVA/FEP, ETFE/EAA/FEP, ETFE/EEA/FEP, ETFE/EMA/FEP, ETFE/EMAA/FEP, ETFE/EMMA/FEP, ETFE/ionomer resin/FEP, ETFE/EVA/HFP, ETFE/EAA/HFP, ETFE/EEA/HFP, ETFE/EMA/HFP, ETFE/EMAA/HFP, ETFE/EMMA/HFP and ETFE/ionomer resin/HFP,
PFA/EVA/PET, PFA/EAA/PET, PFA/EEA/PET, PFA/EMA/PET, PFA/EMAA/PET, PFA/EMMA/PET, PFA/ionomer resin/PET, PFA/EAA/PBT, PFA/EEA/PBT, PFA/EMA/PBT, PFA/EMAA/PBT, PFA/EMMA/PBT and PFA/ionomer resin/PBT,
PFA/EVA/ETFE, PFA/EAA/ETFE, PFA/EEA/ETFE, PFA/EMA/ETFE, PFA/EMAA/ETFE, PFA/EMMA/ETFE, PFA/ionomer resin/ETFE, PFA/EVA/PFA, PFA/EAA/PFA, PFA/EEA/PFA, PFA/EMA/PFA, PFA/EMAA/PFA, PFA/EMMA/PFA, PFA/ionomer resin/PFA, PFA/EVA/FEP, PFA/EAA/FEP, PFA/EEA/FEP, PFA/EMA/FEP, PFA/EMAA/FEP, PFA/EMMA/FEP and PFA/ionomer resin/FEP,
FEP/EVA/PET, FEP/EAA/PET, FEP/EEA/PET, FEP/EMA/PET, FEP/EMAA/PET, FEP/EMMA/PET, FEP/ionomer resiri/PET, FEP/EAA/PBT, FEP/EEA/PBT, FEP/EMA/PBT, FEP/EMAA/PBT, FEP/EMMA/PBT and FEP/ionomer resin/PBT,
FEP/EVA/ETFE, FEP/EAA/ETFE, FEP/EEA/ETFE, FEP/EMA/ETFE, FEP/EMAA/ETFE, FEP/EMMA/ETFE, FEP/ionomer resin/ETFE, FEP/EVA/PFA, FEP/EAA/PFA, FEP/EEA/PFA, FEP/EMA/PFA, FEP/EMAA/PFA, FEP/EMMA/PFA, FEP/ionomer resin/PFA, FEP/EVA/FEP, FEP/EAA/FEP, FEP/EEA/FEP, FEP/EMA/FEP, FEP/EMAA/FEP, FEP/EMMA/FEP and FEP/ionomer resin/FEP.

Of the release film of the present invention, the thickness of the layer A is preferably from 3 to 100 µm, more preferably from 12 to 25 µm. Within this range, the moldability of the film of the layer A tends to be favorable, and the release film can be produced at a low cost. The thickness of the layer B is preferably from 5 to 200 µm, more preferably from 10 to 50 µm. Within this range, the thermoplastic resin for the layer B flows at the time of molding, and it can fill a space formed by the cavity part in a convexo-concave shape of the printed wiring board and a hot plate for pressing, whereby discharge of an adhesive prepreg can be prevented. The thickness of the layer C is preferably from 3 to 100 µm, more preferably from 10 to 25 µm. Within this range, the moldability of the film of the layer C tends to be favorable, the release film can be produced at a low cost, and further, the release film is excellent in toughness and handling properties.

The release film of the present invention is produced preferably by forming each of the layer A, the layer B and the layer C simultaneously or separately by a method of e.g. extrusion, pressure molding or cast molding, and laminating the layers. The laminating method may be a conventional extrusion or laminating, and preferred is co-extrusion, extrusion laminating, dry laminating or thermolaminating. More preferred is extrusion laminating by which molding at a high speed is possible.

The release film of the present invention is employed for production of e.g. printed wiring boards including a rigid printed wiring board, a flexible printed wiring board, a rigid-flexible printed wiring board and a buildup printed wiring board by hot press molding. Further, it may also be employed for production of e.g. semiconductor packages including a Quad Flat Non-Leaded Package, a Small Outline Non-Leaded Package, a Chip Scale/Size Package, a Wafer-Level Chip Scale/Size Package and a Ball Grid Array, by hot press molding.

The release film of the present invention is preferred as a release film for the above printed wiring boards and semiconductor packages.

In the method for producing a printed wiring board, the printed wiring board is produced preferably in such a manner that a plurality of substrates are laminated one on another by means of an adhesive prepreg to constitute a multi-layer laminate, and the release film is inserted between the cavity part in a convexo-concave shape of the multi-layer laminate and a hot plate for pressing, followed by press molding.

Further, in a case of producing a printed wiring board having through-holes on the surface of the multi-layer laminate, it is preferred to insert the release film between the plane having the through-holes and a press plate, followed by press molding. For production of a printed wiring board, it is also preferred to employ e.g. sequential laminating wherein on a part having plating applied thereto, a printed wiring board is further laminated sequentially.

The materials of the printed wiring board are usually a substrate, an adhesive prepreg and the like.

The substrate is produced by impregnating a substrate of woven cloth or non-woven cloth made of e.g. cellulose fiber paper or glass fibers, with a thermosetting resin, followed by curing. Specific examples of the substrate include a glass fiber/epoxy resin complex, a glass fiber/polyimide resin complex, a glass fiber/bismaleimide-triazine resin complex and a silica fiber/polyimide resin complex.

For adhesion of substrates or for adhesion of a substrate to a copper foil or a copper foil having a printed wiring pattern imparted thereon, an adhesive prepreg employing the same type of a resin as the thermosetting resin used for the substrate is employed. The adhesive prepreg is produced by impregnating a base material with a thermosetting resin in an uncured state, and a curing agent and a solvent as the case requires, followed by drying at from 130 to 200°C for from 3 to 5 minutes. The adhesive prepreg is preferably in a semicured state. The gelation time of the adhesive prepreg at 170°C is preferably from 100 to 300 seconds with respect to a glass fiber/semi-cured state epoxy resin type adhesive prepreg, or from 200 to 400 seconds with respect to glass fiber/semi-cured state polyimide resin type adhesive prepreg.

The press molding temperature at the time of production of a printed wiring board is from 100 to 240°C, more preferably from 120 to 220°C. The press molding pressure is preferably from 0.3 to 5 MPa, more preferably from 0.4 to 3 MPa. The press molding time is preferably from 30 to 240 minutes, more preferably from 40 to 120 minutes. As a press plate at the time of press molding, preferred is a stainless steel plate. Further, a flexible flat plate such as a silicone rubber plate may be sandwiched between the release film and the press plate, and the release film may not be used.

For use of the release film, in a case where a laminated printed wiring board has a convexo-concave shape cavity part on both surfaces, it is preferred to employ the release film of the present invention on both sides. Further, in a case where the laminated printed wiring board has a convexo-concave shape cavity part only on one surface, the release film of the present invention is used on the one side having the convexo-concave shape cavity part, and on the other side having no convexo-concave shape cavity part, the release film of the present invention may be employed, or a conventional release film may be employed.

In a method for producing a semiconductor package, the semiconductor package is produced by hot press molding. The semiconductor package is produced in such a manner that a sealing resin is injected and cured in a mold having a semiconductor disposed therein, while the release film is interposed between the surface to be sealed on which a terminal or an electrode is disposed and the inner surface of a mold. The sealing resin may, for example, be an epoxy resin, a polyimide resin or a ceramic.

As the semiconductor, usually e.g. one having each of a plurality of units in a lead flame subjected to wire bonding is employed. The semiconductor is disposed in the cavity of a bottom mold. The lead terminals may be disposed on the periphery of the semiconductor at intervals. Further, they may be disposed on the entire surface or may be disposed only on opposite sides.

The press molding temperature at the time of production of a semiconductor package is from 100 to 240°C, more preferably from 120 to 220°C. The press molding pressure is preferably from 0.3 to 5 MPa, more preferably from 0.4 to 3 MPa. The press molding time is preferably from 30 to 240 minutes, more preferably from 40 to 120 minutes. As the press plate at the time of press molding, a stainless steel plate is preferred.

The release film of the present invention may be used for production of not only the above semiconductor package having each of a plurality of units in a lead flame subjected to wire bonding, but also a semiconductor package having such a structure that terminals which contact with an external connecting terminal such as a soldering ball are exposed from the surface of the sealing resin.

The mechanism how the excellent characteristics of the release film of the present invention are obtained is not clearly understood, but is considered as follows. The material of the layer A is a fluororesin having a low surface energy, whereby the release film has release properties from a multi-layer printed circuit and a press plate. Further, the layer B has a low melting point, and it thereby fills a space formed by the cavity part in a convexo-concave shape of a product to be molded and a hot plate for pressing, whereby discharge of an adhesive prepreg employed for the product to be molded can be prevented.

In production by using the release film of the present invention, wherein a plurality of substrates are laminated one on another by means of an adhesive prepreg to constitute a laminate for a multi-layer substrate, the release film is contacted with the cavity part in a convexo-concave shape of the laminate for a multi-layer substrate including a part at which the adhesive prepreg is exposed, and hot press molding is carried out in such a state, by contacting the layer A side of the release film with the cavity part in a convexo-concave shape, discharge of the adhesive prepreg from the exposed part can be prevented, and the obtained product is excellent in surface smoothness.

Now, the present invention will be explained in further detail with reference to Examples. However, it should be understood that the present invention is by no means restricted to such specific Examples. Examples 1 to 7 are Examples of the present invention, and Examples 8 to 10 are Comparative Examples. For press molding of a multi-layer printed wiring board, for evaluation of discharge of an adhesive prepreg and for evaluation of surface smoothness, the following methods were employed. Press molding of a multi-layer printed wiring board

A cross-sectional view illustrating a multi-layer printed wiring board 10 having a convexo-concave shape cavity part before press molding used in each Example, is shown in Fig. 2. It has such a structure that substrates 5, 7 and 9 and adhesive prepregs 6 and 8 are alternately laminated one on another. The substrates 5, 7 and 9 comprise a glass fiber/epoxy resin complex. For the adhesive prepregs 6 and 8, glass fibers impregnated with an epoxy resin having an epoxy resin content of 54 mass% was employed.

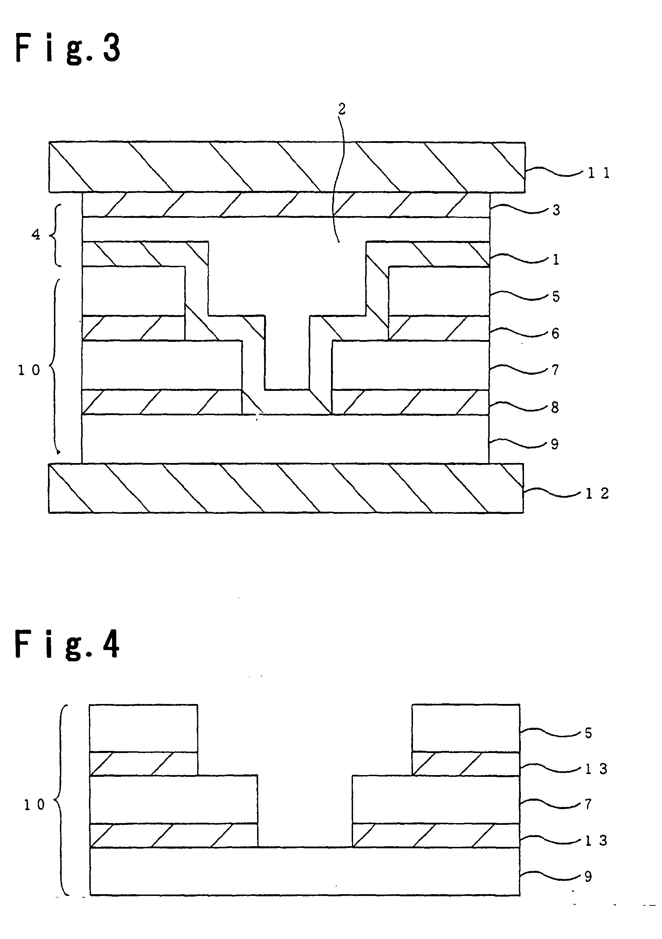

Press molding was carried out in a state as illustrated in Fig. 3 to obtain a printed wiring board 10. In the printed wiring board 10 as illustrated in Fig. 4, the adhesive prepregs 6 and 8 were subjected to thermosetting in a state where they are not discharged to the convexo-concave shape cavity part, and the substrates 5, 7 and 9 were adhered by means of a thermoset adhesive prepreg 13. In Fig. 3, numerical reference 11 and 12 designate a stainless steel plate.

As the press molding conditions of the printed wiring board, press molding was carried out under a pressure of 2 MPa at a temperature of 130°C for 5 minutes, then under a pressure of 2 MPa at a temperature of 190°C for 5 minutes, and then under a pressure of 0.5 MPa at a temperature of 185°C for 5 minutes.

### Evaluation of discharge of adhesive prepreg

The convexo-concave shape cavity part of the printed wiring board obtained by press molding was observed by an electron microscope, and presence or absence of discharge of the adhesive prepreg to the printed wiring board surface was evaluated.

### Evaluation of surface smoothness

The surface state of the printed wiring board was evaluated by visual observation.

### EXAMPLE 1

For a release film, an ETFE film having a thickness of 12 µm (manufactured by Asahi Glass Company, Limited, AFLEX 12N® , melting point: 265°C) for the layer A, and a PET film having a thickness of 25 µm (manufactured by Toray Industries Inc., Lumilar X44® melting point: 265°C) for the layer C were employed. The layer B was prepared by extrusion of EVA (manufactured by Tosoh Corporation, Ultracene 541L® , melting point: 95°C). Then, the layer A and the layer C were bonded on both sides of the layer B by extrusion laminating to prepare a release film having a thickness of 57 µm. The thickness of the layer B was 20 µm.

Using this release film, the layer A side of the release film was contacted with a multi-layer printed wiring board, and the multi-layer printed wiring board was subjected to press molding. The obtained multi-layer printed wiring board was excellent in surface smoothness at the convexo-concave shape cavity part, and substantially no discharge of the adhesive prepreg was observed.

### EXAMPLE 2

A release film having a thickness of 57 µm was prepared in the same manner as in Example 1 except that EAA (manufactured by JPO Co., Ltd., ET184M, melting point: 86°C) was used instead of EVA for the layer B. The thickness of the layer B was 20 µm. A multi-layer printed wiring board was subjected to press molding in the same manner as in Example 1. The obtained multi-layer printed wiring board was excellent in surface smoothness at the convexo-concave shape cavity part, and substantially no discharge of the adhesive prepreg was observed.

### EXAMPLE 3

A release film having a thickness of 57 µm was prepared in the same manner as in Example 1 except that EEA (manufactured by Mitsui-DuPont Polychemicals Co., Ltd., A701, melting point: 96°C) was used instead of EVA for the layer B. The thickness of the layer B was 20 µm. A multi-layer printed wiring board was subjected to press molding in the same manner as in Example 1. The obtained multi-layer printed wiring board was excellent in surface smoothness at the convexo-concave shape cavity part, and substantially no discharge of the adhesive prepreg was observed.

### EXAMPLE 4

A release film having a thickness of 57 µm was prepared in the same manner as in Example 1 except that EMA (manufactured by JPO Co., Ltd., RB5120, melting point: 90°C) was used instead of EVA for the layer B. The thickness of the layer B was 20 µm. A multi-layer printed wiring board was subjected to press molding in the same manner as in Example 1. The obtained multi-layer printed wiring board was excellent in surface smoothness at the convexo-concave shape cavity part, and substantially no discharge of the adhesive prepreg was observed.

### EXAMPLE 5

A release film having a thickness of 57 µm was prepared in the same manner as in Example 1 except that EMAA (manufactured by Mitsui-DuPont Polychemicals Co., Ltd., Nucrel AN4213C® , melting point: 88°C) was used instead of EVA for the layer B. The thickness of the layer B was 20 µm. A multi-layer printed wiring board was subjected to press molding in the same manner as in Example 1. The obtained multi-layer printed wiring board was excellent in surface smoothness at the convexo-concave shape cavity part, and substantially no discharge of the adhesive prepreg was observed.

### EXAMPLE 6

A release film having a thickness of 57 µm was prepared in the same manner as in Example 1 except that EMMA (manufactured by Sumitomo Chemical Co., Ltd., Acryft WH302® , melting point: 94°C) was used instead of EVA for the layer B. The thickness of the layer B was 20 µm. A multi-layer printed wiring board was subjected to press molding in the same manner as in Example 1. The obtained multi-layer printed wiring board was excellent in surface smoothness at the convexo-concave shape cavity part, and substantially no discharge of the adhesive prepreg was observed.

### EXAMPLE 7

A release film having a thickness of 57 µm was prepared in the same manner as in Example 1 except that an ionomer resin (manufactured by Mitsui-DuPont Polychemicals Co., Ltd., Himilan H1702® , melting point: 90°C) was used instead of EVA for the layer B. The thickness of the layer B was 20 µm. A multi-layer printed wiring board was subjected to press molding in the same manner as in Example 1. The obtained multi-layer printed wiring board was excellent in surface smoothness at the convexo-concave shape cavity part, and substantially no discharge of the adhesive prepreg was observed.

### EXAMPLE 8 (COMPARATIVE EXAMPLE)

A release film having a thickness of 54 µm was prepared in the same manner as in Example 1 except that a PET film having a thickness of 12 µm (manufactured by Teijin DuPont Films, NSC, melting point: 265°C) was used for the layer C, and polypropylene (manufactured by Idemitsu Petrochemical Co., Ltd., Y-6005GM, melting point: 130°C) was used for the layer B. The thickness of the layer B was 30 µm. A multi-layer printed wiring board was subjected to press molding in the same manner as in Example 1. With respect to the obtained multi-layer printed wiring board, discharge of the adhesive prepreg resin was observed at the convexo-concave shape cavity part, and the surface smoothness was inadequate. EXAMPLE 9 (COMPARATIVE EXAMPLE)

A release film having a thickness of 54 µm was prepared in the same manner as in Example 8 except that polypropylene (manufactured by Montell SDK Sunrise Ltd., PH803A, melting point: 159°C) was used for the layer B. The thickness of the layer B was 30 µm. A multi-layer printed wiring board was subjected to press molding in the same manner as in Example 1. With respect to the obtained multi-layer printed wiring board, discharge of the adhesive prepreg resin was observed at the convexo-concave shape cavity part, and the surface smoothness was inadequate.

### EXAMPLE 10 (COMPARATIVE EXAMPLE)

A release film having a thickness of 49 µm was prepared in the same manner as in Example 8 except that polyethylene (manufactured by Idemitsu Petrochemical Co., Ltd., Petrocene 1384R® , melting point: 110°C) was used for the layer B. The thickness of the layer B was 25 µm. A multi-layer printed wiring board was subjected to press molding in the same manner as in Example 1. With respect to the obtained multi-layer printed wiring board, discharge of the adhesive prepreg resin was observed at the convexo-concave shape cavity part, and the surface smoothness was inadequate.

The release film of the present invention can be used for production of printed wiring boards, semiconductor packages and the like by hot press molding. It is excellent in release properties, whereby it can increase uniformity of pressing, it can prevent discharge of an adhesive prepreg and it is excellent in surface smoothness. Further, the release film of the present invention is excellent in economical efficiency since the fluororesin layer is thin.

## Claims

1. Use of a release film (4) having a three-layer structure consisting of a layer A (1), a layer B (2) and a layer C (3) laminated in this order, wherein the layer A (1) comprises a fluororesin having a melting point higher than the press molding temperature of a product to be molded, which is from 100 to 240°C, the layer B (2) comprises a thermoplastic resin, which is at least one member selected from the group consisting of an ethylene/vinyl acetate copolymer, an ethylene/acrylic acid copolymer, an ethylene/ethyl acrylate copolymer, an ethylene/methyl acrylate copolymer, an ethylene/methacrylic acid copolymer, an ethylene/methyl methacrylate copolymer and an ionomer resin, having a melting point of from 70 to 100°C, and the layer C (3) comprises a fluororesin or a non-fluororesin having a melting point higher than the above press molding temperature, in a method for producing a printed wiring board or a semiconductor package.

2. The use according to claim 1, wherein the fluororesin for the layer A (1) and/or the layer C (3) is a copolymer of tetrafluoroethylene with a comonomer.

3. The use according to claim 1 or 2, wherein the fluororesin for the layer A (1) and/or the layer C (3) is a tetrafluoroethylene/ethylene copolymer, a tetrafluoroethylene/perfluoro(alkyl vinyl ether) copolymer or a tetrafluoroethylene/hexafluoropropylene copolymer.

4. The use according to any one of claims 1 to 3, wherein the thickness of the layer A (1) is from 3 to 100 µm, the thickness of the layer B (2) is from 5 to 200 µm, and the thickness of the layer C (3) is from 3 to 100 µm.

5. The use according to any one of claims 1 to 4, wherein the release film (4) is laminated by coextrusion, extrusion laminating, dry laminating or thermolaminating.

## Patentansprüche

1. Verwendung einer Trennfolie (4) mit einer Dreischichtstruktur, bestehend aus einer Schicht A (1), einer Schicht B (2) und einer Schicht C (3), welche in dieser Reihenfolge laminiert sind, wobei die Schicht A (1) ein Fluorharz mit einem Schmelzpunkt von höher als der Preßformgebungstemperatur eines zu formenden Produkts, die von 100 bis 240°C beträgt, umfaßt, die Schicht B (2) ein thermoplastisches Harz umfaßt, welches mindestens ein Vertreter, ausgewählt aus der Gruppe, bestehend aus einem Ethylen/Vinylacetat-Copolymer, einem Ethylen/Acrylsäure-Copolymer, einem Ethylen/Ethylacrylat-Copolymer, einem Ethylen/Methylacrylat-Copolymer, einem Ethylen/Methacrylsäure-Copolymer, einem Ethylen/Methylmethacrylat-Copolymer und einem lonomerharz, ist, welches einen Schmelzpunkt von 70 bis 100°C aufweist, und die Schicht C (3) ein Fluorharz oder ein Nicht-Fluorharz mit einem Schmelzpunkt von höher als der vorstehenden Preßformgebungstemperatur umfaßt, in einem Verfahren zur Herstellung einer Leiterplatte bzw. gedruckten Verdrahtungsplatte oder eines Halbleiterbauteils.

2. Verwendung nach Anspruch 1, wobei das Fluorharz für die Schicht A (1) und/oder die Schicht C (3) ein Copolymer von Tetrafluorethylen mit einem Comonomer ist.

3. Verwendung nach Anspruch 1 oder 2, wobei das Fluorharz für die Schicht A (1) und/oder die Schicht C (3) ein Tetrafluorethylen/Ethylen-Copolymer, ein Tetrafluorethylen/Perfluor(alkylvinylether)-Copolymer oder ein Tetrafluorethylen/Hexafluorpropylen-Copolymer ist.

4. Verwendung nach einem der Ansprüche 1 bis 3, wobei die Dicke der Schicht A (1) von 3 bis 100 µm, die Dicke der Schicht B (2) von 5 bis 200 µm und die Dikke der Schicht C (3) von 3 bis 100 µm beträgt.

5. Verwendung nach einem der Ansprüche 1 bis 4, wobei die Trennfolie (4) durch Coextrusion, Extrusionslaminieren, Trockenlaminieren oder Thermolaminieren laminiert ist.

## Revendications

1. Utilisation d'un film de séparation (4) ayant une structure à trois couches constituée d'une couche A (1), d'une couche B (2) et d'une couche C (3) stratifiées dans cet ordre, dans lequel la couche A (1) comprend une résine fluorée ayant un point de fusion supérieur à la température de moulage à la presse d'un produit devant être moulé, laquelle est de 100 à 240°C, la couche B (2) comprend une résine thermoplastique, qui est au moins un élément choisi dans le groupe constitué par un copolymère d'éthylène/acétate de vinyle, un copolymère d'éthylène/acide acrylique, un copolymère d'éthylène/acrylate d'éthyle, un copolymère d'éthylène/acrylate de méthyle, un copolymère d'éthylène/acide méthacrylique, un copolymère d'éthylène/méthacrylate de méthyle et une résine ionomère, ayant un point de fusion de 70 à 100°C, et la couche C (3) comprend une résine fluorée ou une résine non fluorée ayant un point de fusion supérieur à la température de moulage à la presse ci-dessus, dans un procédé pour produire une carte à circuit imprimé ou un boîtier pour semi-conducteur.

2. Utilisation selon la revendication 1, dans laquelle la résine fluorée pour la couche A (1) et/ou la couche C (3) est un copolymère de tétrafluoroéthylène avec un comonomère.

3. Utilisation selon la revendication 1 ou 2, dans laquelle la résine fluorée pour la couche A (1) et/ou la couche C (3) est un copolymère de tétrafluoroéthylène/éthylène, un copolymère de tétrafluoroéthylène/perfluoro(alkylvinyléther) ou un copolymère de tétrafluoroéthylène/hexafluoropropylène.

4. Utilisation selon l'une quelconque des revendications 1 à 3, dans laquelle l'épaisseur de la couche A (1) est de 3 à 100 µm, l'épaisseur de la couche B (2) est de 5 à 200 µm, et l'épaisseur de la couche C (3) est de 3 à 100 µm.

5. Utilisation selon l'une quelconque des revendications 1 à 4, dans laquelle le film de séparation (4) est stratifié par coextrusion, stratification par extrusion, stratification à sec ou stratification thermique.
